# EUROPÄISCHE PATENTANMELDUNG

(11) **EP 1 690 837 A1**
(43) Veröffentlichungstag der Anmeldung: **16.08.2006**
(21) Anmeldenummer: 05100947.0
(22) Anmeldetag: 10.02.2005
(51) Int. Cl.: C03C 3/06, C03B 19/14

(54) **Synthetisches Quarzglas sowie Verfahren zur Herstellung eines Quarzglas-Körpers**

(71) Anmelder: Schott AG, 55122 Mainz (DE)
(72) Erfinder: Martin, Rolf, 07743 Jena (DE); Von der Gönna, Gordon, Dr., 07743 Jena (DE); Natura, Ute, Dr., 07743 Jena (DE)
(74) Vertreter: Patentanwälte Kewitz & Kollegen

(57) **Zusammenfassung**

Die Erfindung betrifft ein synthetisches Quarzglas, herstellbar durch Direktabscheidung mittels Flammenhydrolyse eines Silizium-Precursors, insbesondere eines chlorhaltigen Silizium-Precursors, welches Quarzglas bei einer Bestrahlung mit Laserpulsen bei einer Wellenlänge von 193 nm, bei einer Energiedichte (H) von bis zu H = 1,5 mJ/cm² und bei einer Wiederholfrequenz der Laserpulse von bis zu R = 4 kHz gekennzeichnet ist durch die folgenden Eigenschaften:
- im Bereich von Energiedichten von bis zu 1,5 mJ/cm² steigt die Gleichgewichtsabsorption des Quarzglases sublinear mit der Energiedichte für alle Wiederholfrequenzen der Laserpulse;
- die Abhängigkeit der Gleichgewichtsabsorption von der Wiederholfrequenz der Laserpulse ist sublinear; und
- der Zusammenhang von Gleichgewichtsabsorption und Energiedichte (H) lässt sich als Funktion von H^{1,7} beschreiben;
wobei der H₂-Gehalt mindestens 0,2·10¹⁸ Moleküle/cm³ beträgt.

Weitere Gesichtspunkte der Erfindung betreffen ein Verfahren zur Herstellung eines solchen synthetischen Quarzglases, insbesondere wobei das Quarzglas auf einer oberen Haltetemperatur im Bereich von 950°C bis 1150°C für mindestens 10h gehalten wird, und auf eine Kühlendtemperatur mit einer Geschwindigkeit von 1 K/h bis 20 K/h abgekühlt wird.

## Beschreibung

### Gebiet der Erfindung

Die Erfindung betrifft allgemein die Herstellung von synthetischem Quarzglas und betrifft insbesondere die Herstellung eines synthetischen Quarzglases mit geringer Änderung der Absorption bei Änderung der Energiedichte bei einer Laserbestrahlung im Wellenlängenbereich von etwa 193nm. Die Energiedichte der Laserbestrahlung liegt dabei in Größenordnungen, wie sie bei optischen Systemen für die Mikrolithografie üblich sind. Bevorzugtes Anwendungsgebiet dieser Erfindung ist die Herstellung und die Verwendung von synthetischem Quarzglas zur Herstellung von Komponenten für die Mikrolithografie bei Wellenlängen von 193 nm.

### Hintergrund der Erfindung

Synthetisches Quarzglas wurde und wird auch zukünftig in größerem Umfang als Rohmaterial für optische Linsen in Objektiven eingesetzt, welche in der Halbleiterindustrie zur fotolithografischen Herstellung elektronischer Bauteile (Prozessoren, Speicherschaltkreise, etc.) verwendet werden. Besondere Bedeutung haben dabei die Systeme, welche mit Laserstrahlung der Wellenlänge von ca. 193nm arbeiten. Als Strahlungsquelle für solche 193nm-Systeme werden ArF-Excimerlaser verwendet, welche im Pulsbetrieb mit Pulswiederholungsfrequenzen (Rep.-raten) von 1kHz bis 4kHz oder darüber hinaus arbeiten.

Aus den hohen Anforderungen, welche an die Güte der Objektive für 193nm Arbeitswellenlänge gestellt werden, leiten sich auch hohe Anforderungen an die Materialeigenschaften des für die Objektivlinsen verwendeten Quarzglases ab. Wesentliche Materialanforderungen an das eingesetzte Quarzglas ergeben sich aus der Wirkung, welche gepulste 193nm-Laserstrahlung auf Quarzglas ausübt. Die daraus abgeleiteten Materialspezifikationen sollen durch konstante Abbildungsleistung der Objektive möglichst konstante Fertigungsbedingungen beim fotolithografischen Prozess sicherstellen.

Die Wirkung von gepulster 193nm-Laserstrahlung auf die Eigenschaften von Quarzglas läßt sich in Kurzzeiteffekte und in Langzeiteffekte einteilen. Langzeiteffekte entstehen durch Langzeitlaserbestrahlung, d.h. nach Pulszahlen im Gigabereich (1Gigapulse = 10⁹ Pulse). Wichtigste Langzeiteffekte sind die Erhöhung der durch Laserstrahlung induzierten Absorption bei Wellenlängen um 193nm sowie Änderungen der optischen Weglänge (OPD) durch Längen- und Brechzahländerungen in bestrahltem Quarzglas. Kurzzeiteffekte entstehen, wenn Quarzglas nach fertigungsbedingten Bestrahlungspausen erneut bestrahlt wird oder plötzlichen Energiedichteänderungen ausgesetzt ist. Wichtigster, bei solchen Änderungen stattfindender Kurzzeiteffekt im Quarzglas ist die Änderung der Absorption bei 193nm in Abhängigkeit von der Energiedichte der optischen Strahlung, welche allgemein als RDP (Rapid Damage Process) bezeichnet wird. Da sich im fotolithografischen Herstellprozess weder Bestrahlungspausen noch kurzzeitige Energiedichteänderungen vermeiden lassen, ist RDP, d.h. die Änderung der Absorption in Abhängigkeit von der Energiedichte der optischen Strahlung, für einen vorgegebenen Energiedichtebereich und für vorgegebene Wiederholfrequenzen der Laserpulse spezifiziert.

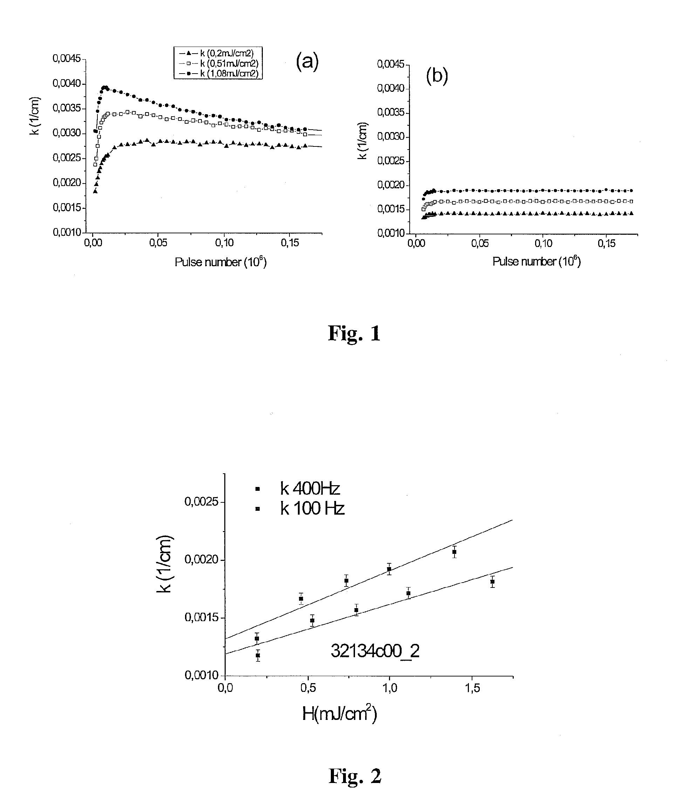

Bei der Materialqualifizierung von Quarzglas zum Einsatz in 193nm Systemen wurde bisher folgende Vorgehensweise gewählt:
a) Zunächst wird die Transmission einer Quarzglasprobe bei 193nm bei 4 unterschiedlichen Energiedichten im Bereich bis 1.5mJ/cm² nach Beaufschlagung der Proben mit einer bestimmten Pulszahl (normalerweise etwa 250.000 Pulse) gemessen. Die Quarzglasprobe wurde dabei nicht vorbestrahlt.
b) Der sich einstellende Verlauf der Transmission ist beispielhaft in der Fig. 1a für drei unterschiedliche Energiedichten dargestellt. Dieser Verlauf der Transmission wurde herkömmlich durch eine Überlagerung einer linearen Funktion und einer Exponentialfunktion beschrieben und das Absolutglied des Kurvenfits wurde als die zur eingestellten Energiedichte gehörige Transmission registriert. Nur bei sehr geringen Energiedichten stellte sich ein Gleichgewichtszustand der Transmission ein, bei höheren Energiedichten war ein stetiger Anstieg der Transmission nach einem anfänglichen starken Abfall zu beobachten.
c) Die (noch von der Probenlänge abhängigen) Transmissionswerte wurden in von der Probenlänge unabhängige Absorptionwerte k (d.h. eine reine Stoffeigenschaft) umgerechnet. Der Anstieg der Absorption k mit der Energiedichte H, also die Größe dk/dH, ist ein Maß für die Stärke des RDP und wird im Folgenden mit RDP bezeichnet. Diese Größe wurde zur Charakterisierung von Quarzglasproben verwendet.

Eine Auslegung der Mess-Sensorik zur Messung der Absorption an den Lasermessplätzen für Wiederholfrequenzen der Laserpulse von oberhalb etwa 400Hz war bisher nicht angedacht, weshalb man sich bisher auf die Begrenzung des Messprogramms zur Überprüfung und Charakterisierung der RDP auf Wiederholfrequenzen der Laserpulse von kleiner als 400Hz beschränkte. Ein wichtiger Grund für diese Beschränkung auf niedrige Wiederholfrequenzen waren die vergleichsweise hohen Kosten, da die Auslegung einer Messapparatur zur Charakterisierung von Quarzglasproben bei hohen Wiederholfrequenzen der Laserpulse sehr kompliziert und aufwändig ist. Bis zu diesen Wiederholfrequenzen erwies sich bei den Messungen (bei jeweils konstanter Energiedichte und ohne Vorbestrahlung) die Absorption als annähernd linear von der Wiederholfrequenz abhängig, so dass man es als ausreichend ansah, von der Wiederholfrequenz bei 400Hz auf die in der fotolithografischen Fertigung üblichen Wiederholfrequenzen von 2kHz und 4kHz linear zu extrapolieren.

In einer Reihe von aufwändigen Versuchen haben die Erfinder herausgefunden, dass die obige Vorgehensweise zur Charakterisierung von Quarzglasproben nicht ausreichend ist, insbesondere zur Charakterisierung von synthetischem Quarzglas unter Bedingungen, wie sie bei angedachten Anwendungen in mikrolithographischen Belichtungsvorrichtungen, insbesondere Photosteppern, üblich sein werden. Diese Erkenntnis bildete schließlich die Grundlage für die Bereitstellung von synthetischem Quarzglas mit noch besseren Eigenschaften im angedachten Einsatzbereich.

### Zusammenfassung der Erfindung

Aufgabe der vorliegenden Erfindung war es somit, ein verbessertes synthetisches Quarzglas und ein Verfahren zu dessen Herstellung sowie zur Herstellung eines Quarzglaskörpers mit noch besseren Eigenschaften bereitzustellen, insbesondere mit besseren Eigenschaften unter Bedingungen in mikrolithographischen Belichtungsvorrichtungen.

Diese und weitere Aufgaben werden durch ein synthetisches Quarzglas nach Anspruch 1, durch ein Verfahren zu dessen Herstellung nach Anspruch 7 sowie durch ein Verfahren zur Herstellung eines Quarzglaskörpers nach Anspruch 17 gelöst. Weitere vorteilhafte Ausführungsformen sind Gegenstand der rückbezogenen Ansprüche.

Gemäß einem ersten Gesichtspunkt der vorliegenden Erfindung wird ein synthetisches Quarzglas bereitgestellt, herstellbar durch Direktabscheidung mittels Flammenhydrolyse eines Silizium-Precursors, insbesondere eines chlorhaltigen Silizium-Precursors, wie beispielsweise Silizium-Tetrachlorid, welches Quarzglas bei einer Bestrahlung mit Laserpulsen bei einer Wellenlänge von 193 nm, bei einer Energiedichte (H) von bis zu H = 1,5 mJ/cm² und bei einer Wiederholfrequenz der Laserpulse von bis zu R = 4 kHz, gekennzeichnet ist durch die folgenden Eigenschaften:
- im Bereich von Energiedichten von bis zu 1,5 mJ/cm² steigt die Gleichgewichtsabsorption des Quarzglases sublinear mit der Energiedichte für alle Wiederholfrequenzen der Laserpulse;
- die Abhängigkeit der Gleichgewichtsabsorption von der Wiederholfrequenz der Laserpulse ist sublinear; und
- der Zusammenhang von Gleichgewichtsabsorption und Energiedichte (H) lässt sich als Funktion von H^{1,7} beschreiben;
wobei der H₂-Gehalt mindestens 0,2· 10¹⁸ Moleküle/cm³ beträgt.

Gemäß einem weiteren Gesichtspunkt der vorliegenden Erfindung wird ein Verfahren zur Herstellung eines Körpers aus einem synthetischen Quarzglas, insbesondere aus einem synthetischen Quarzglas gemäß dem vorstehenden Absatz, durch Direktabscheidung eines Quarzglas-Rohteils mittels Flammenhydrolyse eines Silizium-Precursors, insbesondere eines chlorhaltigen Silizium-Precursors, bereitgestellt, wobei das Quarzglas-Rohteil
- auf einer oberen Haltetemperatur im Bereich von 950°C bis 1150°C, vorzugsweise 1050°C bis 1100°C, für mindestens 10h, bevorzugter für mindestens 20h, gehalten wird, und
- auf eine Kühlendtemperatur mit einer mittleren Abkühlgeschwindigkeit von 1 K/h bis 20 K/h, vorzugsweise von 2 K/h bis 5 K/h, abgekühlt wird,
und der H₂-Gehalt des Quarzglaskörpers auf mindestens 0,2· 10¹⁸ Moleküle/cm³ eingestellt wird.

Gemäß einem weiteren Gesichtspunkt der vorliegenden Erfindung wird ein Verfahren zur Herstellung eines Quarzglaskörpers aus einem Quarzglas-Rohteil aus einem synthetischen Quarzglas wie vorstehend beschrieben bereitgestellt, wobei eine optische Absorption des Quarzglas-Rohteils für eine Mehrzahl von Laserpulsen bei einer Wellenlänge von 193nm und bei einer Energiedichte von bis zu H = 1,5 mJ/cm² mit einer vorbestimmten Wiederholfrequenz gemessen wird, nachdem das Quarzglas-Rohteil mit zumindest 2· 10⁶ Laserpulsen, bevorzugter mit zumindest 3· 10⁶ Laserpulsen, mit einer Energiedichte von zumindest 2,5 mJ/cm², bevorzugter von zumindest 3 mJ/cm², bestrahlt wurde, und das Quarzglas-Rohteil ausgesondert oder speziell weiterbehandelt wird, wenn sich kein Gleichgewichtswert für die optische Absorption bei der Messung einstellt.

### Figurenübersicht

Nachfolgend wird die Erfindung in beispielhafter Weise und unter Bezugnahme auf die beigefügten Zeichnungen ausführlicher beschrieben werden, woraus sich weitere Merkmale, Vorteile und zu lösende Aufgaben ergeben werden und worin:
- Fig. 1a: eine gemäß dem Stand der Technik gemessene Absorption einer identischen Quarzglasprobe bei verschiedenen Energiedichten zeigt;
- Fig. 1b: eine mit einem erfindungsgemäßen Messverfahren gemessene Absorption für die Quarzglasprobe gemäß der Fig. 1a bei verschiedenen Energiedichten zeigt;
- Fig. 2: den gemessenen Zusammenhang zwischen der Gleichgewichtsabsorption und der eingestrahlten Energiedichte einer Quarzglasprobe sowie den Versuch einer linearen Regression auf der Grundlage der Messpunkte darstellt;
- Fig. 3: die Gleichgewichtsabsorption der Quarzglasprobe gemäß der Fig. 2 als Funktion der Wiederholfrequenz der Laserpulse für verschiedene Energiedichten darstellt;
- Fig. 4: die Gleichgewichtsabsorption der Quarzglasprobe gemäß der Fig. 2 als Funktion der Wiederholfrequenz der Laserpulse für verschiedene Energiedichten und noch höhere Wiederholfrequenzen darstellt;
- Fig. 5: in einer vergleichenden Darstellung die Extrapolation auf die Gleichgewichtsabsorption bei hohen Wiederholfrequenzen der Laserpulse für eine Quarzglasprobe gemäß dem herkömmlichen linearen Modell und gemäß der vorliegenden Erfindung darstellt;
- Fig. 6: den Zusammenhang zwischen der Energiedichte und der Gleichgewichtsabsorption für eine Quarzglasprobe bei verschiedenen Wiederholfrequenzen der Laserpulse gemeinsam mit einer Modellkurve gemäß der vorliegenden Erfindung zeigt;
- Fig. 7: den gemessenen Zusammenhang zwischen der Gleichgewichtsabsorption und der durch Laserpulse deponierten Dosis für die Messwerte gemäß der Fig. 6 darstellt;
- Fig. 8a: eine mit einem herkömmlichen Messverfahren gemessene Transmission einer Quarzglasprobe als Funktion der Anzahl von zur Messung verwendeten Laserpulse zeigt; und
- Fig. 8b: die mit dem erfindungsgemäßen Messverfahren für eine erfindungsgemäße Quarzglasprobe gemessene Transmission als Funktion der Anzahl von zur Messung verwendeten Laserpulsen zeigt.

### Ausführliche Beschreibung von bevorzugten Ausführungsbeispielen

Die vorliegende Erfindung basiert auf der Verwendung von synthetischem Quarzglas, vorrangig solchem, das unter der Handelsbezeichnung Lithosil™ Q1 E193 von der Anmelderin seit Jahren gefertigt wird. Dabei handelt es sich um ein nach dem Flammenhydrolyseverfahren durch Direktabscheidung aus einem Silizium-Precursor hergestelltes, hochreines synthetisches Quarzglas, insbesondere auch für den Einsatz in der Fotolithografie, als Rohmaterial für Objektivlinsen der Arbeitswellenlängen 248nm und 193nm. Bei der Flammenhydrolyse wird das Quarzglas aus einem siliziumhaltigen Precursor direkt abgeschieden, wie beispielhaft in der WO 98/40319 der Anmelderin offenbart, deren Inhalt hiermit ausdrücklich im Wege der Bezugnahme mit in dieser Anmeldung beinhaltet sei.

### Modifizierte Messvorschrift

In einer Reihe von Versuchen zur Bestimmung des RDP konnte nachgewiesen werden, dass die ursprüngliche Messvorschrift, wie diese vorstehend anhand der Fig. 1a beschrieben worden ist, ungenügend ist. So wurde klar, dass am Anfang der Bestrahlung eine Reihe von Defekten (insbes. ODC - oxygen deficiency center) ausgeheilt werden und späterhin für die Eigenschaften des Materials keine Rolle spielen. Es erwies sich deshalb als wichtig, diese Defekte zu beseitigen. Besonders geeignet ist dabei eine Vorbestrahlung des späteren Messflecks in der Quarzglasprobe auf dem Lasermessplatz. Es konnte gezeigt werden, dass sich bei einer Bestrahlung mit 2 Millionen Laserpulsen bei einer Energiedichte von 3mJ/cm² ein Zustand einstellte, in dem bei späteren Messungen innerhalb weniger 1000 Laserpulse bei jeder Energiedichte ein Gleichgewichtszustand der Transmission erreicht wurde.

Der Unterschied von Absorptionsmessungen mit und ohne Vorbestrahlung wird aus dem Vergleich der Fig. 1a und Fig. 1b deutlich. Ohne Vorbestrahlung (vgl. Fig. 1a) stellt sich ein Gleichgewichtswert der Transmission nicht rasch ein. Dies birgt die Gefahr, dass in Messungen zur Charakterisierung einer Probe die Probe nicht ausreichend lange bestrahlt wird, sodass die Charakterisierung der Probe aufgrund von Nichtgleichgewichts-Parametem erfolgt. Im Gegensatz dazu stellt sich bei Vorbestrahlung der Probe (vgl. Fig. 1b) im Verlauf der Messung schnell ein Gleichgewichtswert der Transmission ein, der ohne weiteres in einen für das Material aussagekräftige, dickenunabhängige Absorption umgerechnet werden kann.

Somit werden erfindungsgemäß zur Charakterisierung der Quarzglasproben Gleichgewichtsabsorptionen bzw. -transmissionen unter den folgenden Messbedingungen bestimmt: die optische Absorption von Quarzglas-Rohteilen wird für eine Mehrzahl von Laserpulsen bei einer Wellenlänge von 193nm und bei einer Energiedichte von bis zu H = 1,5 mJ/cm² mit einer vorbestimmten Wiederholfrequenz gemessen, nachdem das Quarzglas-Rohteil mit zumindest 2. 10⁶ Laserpulsen, bevorzugter mit zumindest 3· 10⁶ Laserpulsen, mit einer Energiedichte von zumindest 2,5 mJ/cm², bevorzugter von zumindest 3 mJ/cm², bestrahlt wurde.

### RDP-Messungen bei niedrigen Wiederholfrequenzen und Entwicklung eines Modells zur Beschreibung des Verhaltens der Gleichgewichtsabsorption

Die RDP-Messungen bis zu einer Wiederholfrequenz der Laserpulse von 400Hz wurden nun für das synthetische Quarzglas Lithosil ™ Q1 E193 (Standardqualität) und für einige experimentell abgeänderte Modifikationen dieser Standardqualität durchgeführt. Herstellbedingungen, Wasserstoffgehalt (H₂) und RDP-Messwerte sind in Tab. 1 zusammengefasst.

**Tab. 1: Messungen des RDP an Lithosil-Proben verschiedener Herstellmethoden**

| | 98042C00-2 | 32124C51-3 | 30114C00-2 |
|---|---|---|---|
| Schmelzverfahren | Vertikalschmelze | Horizontalschmelze und Senken | Horizontalschmelze |
| Zusätzliche nachträgliche Kühlung der Probe | nein | nein | nein |
| H₂ [10¹⁸/cm³] | 1,9 | 1,5 | 2,6 |
| k₀ [10⁻³/cm] | 1,65 | 1,26 | 1,28 |
| dk/dH [10⁻⁴/cm] | 5,6 | 4,8 | 4,6 |

Die in der Tabelle angegebenen Schmelzverfahren entsprechen dem in der WO 98/40319 der Anmelderin beschriebenen Schmelzverfahren, wobei sich die Begriffe "horizontal" und "vertikal" auf die Ausrichtung der Muffel und der zwei gegenüberliegend angeordneten Öffnungen zum Einführen der Vorform und des Brenners beziehen. Mit "Senken" wird in der Tab. 1 das nachträgliche Umformen der Vorform (ingot) bezeichnet, beispielsweise zu einem Zylinder mit größerem Durchmesser und unter erneuter Wärmebehandlung.

Die Messungen ergaben, dass sich nach einer Vorbestrahlung an den Proben reproduzierbare Gleichgewichtstransmissionen für die einzelnen Energiedichten der Laserstrahlung bestimmen lassen. Allerdings war eine lineare Regression der Messwerte zur Beschreibung der Abhängigkeit der Größe dk/dH überraschenderweise ungeeignet. Die ermittelten Kurven wiesen vielmehr auf eine sublineare Abhängigkeit der Gleichgewichtsabsorption von der Energiedichte hin, wie in der Fig. 2 gezeigt, in der die gemessene Gleichgewichtsabsorption für zwei unterschiedliche Wiederholfrequenzen der Laserpulse und unterschiedliche Energiedichten dargestellt ist. Die lineare Regression ist in der Fig. 2 als Hilfe eingezeichnet, beschreibt jedoch die ermittelte Abhängigkeit ersichtlich unzureichend.

Wie der Tab. 1 ferner entnehmbar ist, führen unterschiedliche Herstellbedingungen zu unterschiedlichen Werten für dk/dH. Dieser Wert eignet sich somit grundsätzlich für eine Optimierung der Herstellbedingungen.

Zur Beschreibung des RDP wurde nun ein Modell erarbeitet, das nachfolgend anhand des Ausführungsbeispiels Lithosil ™ Q1 E193 näher erläutert wird, jedoch grundsätzlich auch auf andere Quarzglastypen anwendbar ist. Dieses Modell beruht einerseits darauf, dass die Abhängigkeit der Transmission von der Bestrahlungsdauer durch mindestens zwei Zeitkonstanten beschrieben werden muss, und andererseits darauf, dass die gleiche gesamte linear pro Zeit eingetragene Energie, d.h. Wiederholfrequenz multipliziert mit der Energiedichte, für verschiedene Energiedichten und Wiederholfrequenzen keine gleiche Wirkung zeigt, da sich experimentell bei höheren Energiedichten stets auch höhere Absorptionswerte zeigten. Deshalb wurde ein mathematisches Modell aufgestellt, das darauf beruht, dass zur gemessenen Absorption zwei unterschiedliche Defekte D1, D2 beitragen, denen unterschiedliche Relaxationskonstanten zugeordnet werden konnten. Gemäß diesem Modell wird die Defektstufe D1 bei kleinen Energiedichten gefüllt, während bei hohen Energiedichten eine Anhebung der Ladungsträger von der Stufe D1 zu der höheren Stufe D2 erfolgt und somit bei hohen Energiedichten die Besetzung der Stufe D1 geringer ist als bei kleinen Energiedichten. Mit diesem Modell konnten die vorstehend beschriebenen Abhängigkeiten von dk/dH zufrieden stellend beschrieben werden.

### Messungen bei hohen Wiederholfrequenzen

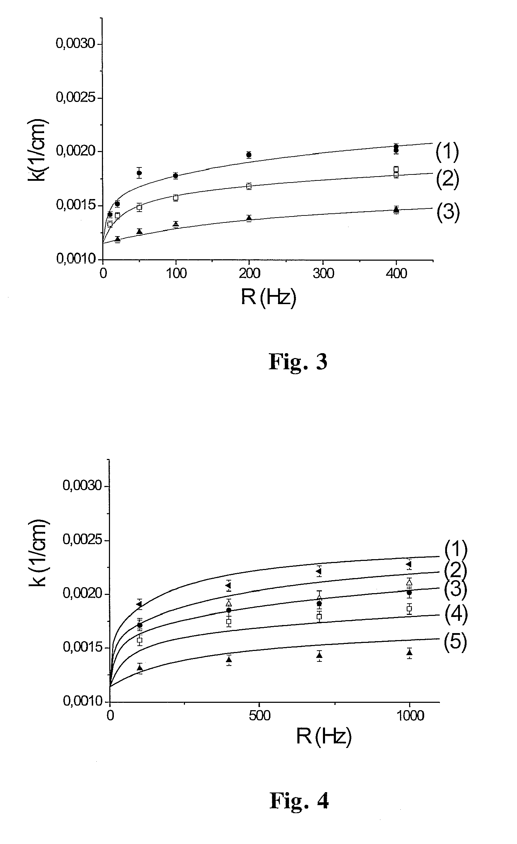

Aus diesem Modell ergab sich die Vorhersage, dass die Absorption von synthetischem Quarzglas nichtlinear von der Wiederholfrequenz abhängt. Zur Überprüfung dieser Vorhersage wurde die Abhängigkeit der Absorption von der Wiederholfrequenz zunächst für Frequenzen unterhalb von etwa 400Hz gemessen. Diese Messungen sind in der Fig. 3 zusammengefasst. Klar erkennbar ist die nichtlineare Abhängigkeit. In der Fig. 3 sind auch Kurvenfits eingezeichnet, die sich aus dem vorstehend diskutierten Modell ergeben.

Das Modell ergab, dass die Abweichungen zwischen der bisher angenommenen linearen Abhängigkeit und der vom Modell vorhergesagten nichtlinearen Abhängigkeit für hohe Frequenzen besonders stark sein sollten. Zur Überprüfung dieser Vorhersage und veranlasst durch das vorstehend erläuterte Modell wurde deshalb die Absorption gemäß der vorliegenden Anmeldung erstmalig auch für vergleichsweise hohe Frequenzen ermittelt, wie in der Fig. 4 zusammengefasst, insbesondere für Frequenzen bis etwa 1 kHz. Darin ist die nichtlineare Abhängigkeit noch besser ersichtlich als in der Fig. 3. In die Fig. 4 sind auch Kurvenfits für die Messpunkte eingezeichnet, die auf dem vorstehend diskutierten Modell beruhen und eine hervorragende Übereinstimmung mit den gemessenen Werten ermöglichten.

### Messverhalten bei hohen Wiederholfrequenzen

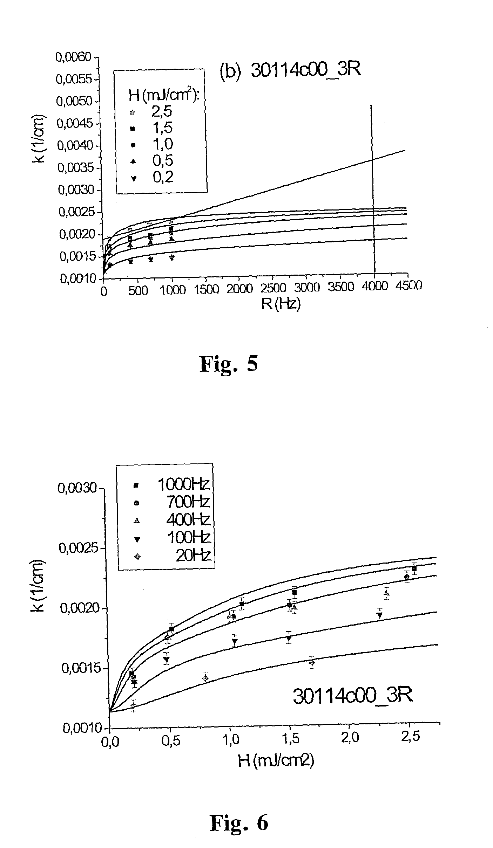

Wie aus der Fig. 4 ersichtlich, kann für hohe Wiederholfrequenzen der Laserpulse mit Hilfe des vorstehend diskutierten Modells eine Sättigung der Gleichgewichtsabsorption vorhergesagt werden. Die sich daraus ergebenden Konsequenzen sind in der vergleichenden Darstellung gemäß der Fig. 5 zusammengefasst, in der der Zusammenhang zwischen Gleichgewichtsabsorption und Wiederholfrequenz für sich aus dem Modell für verschiedene Energiedichten ergebende Modellkurven und für die herkömmlich angenommene lineare Extrapolation der Messwerte bei niedrigen Wiederholfrequenzen bzw. Messfrequenzen dargestellt ist.

Gemäß der Fig. 5 ist davon auszugehen, dass der Wert der Gleichgewichtsabsorption bei den für mikrolithographische Anwendungen erforderlichen hohen Wiederholfrequenzen im Bereich von einigen kHz tatsächlich um den Faktor 2 bis 3 niedriger liegt als aufgrund der linearen Extrapolation angenommen.

### Zusätzliche Verifikation des Modells

Aus dem vorstehend diskutierten Modell ergibt sich ferner, dass auch die Energiedichte H und die sich einstellende Gleichgewichtsabsorption in einem nichtlinearen Zusammenhang stehen, wobei die funktionale Abhängigkeit am besten mit k = f(H^{1,7}) beschrieben werden kann.

Zur weiteren Verifikation des Modells ist in der Fig. 6 der Zusammenhang von Energiedichte und Gleichgewichtsabsorption an einer Quarzglasprobe bei verschiedenen Wiederholfrequenzen dargestellt. Die eingezeichneten Kurven beruhen auf der Abhängigkeit gemäß dem vorstehend diskutierten Modell mit H^{1,7} und stimmen gut mit den Messwerten überein.

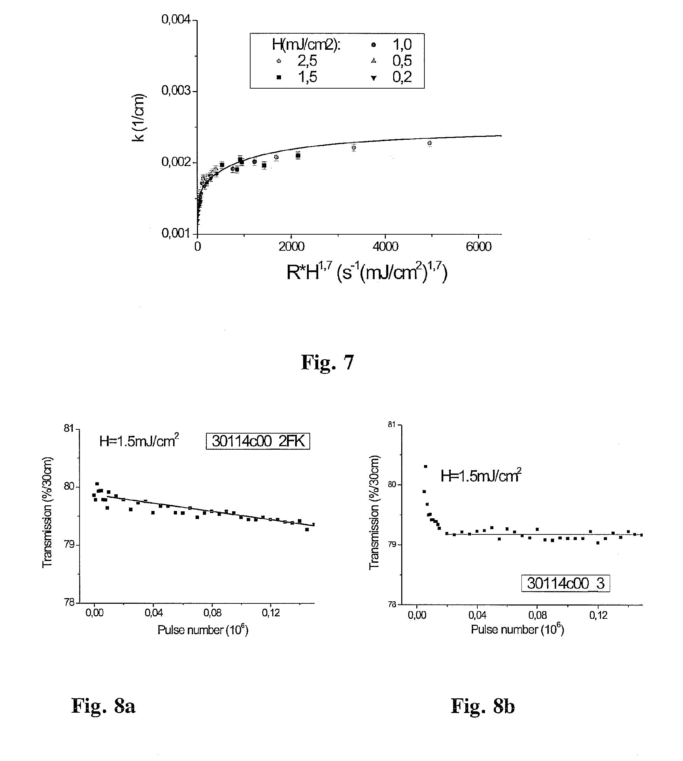

Die Fig. 7 gibt den funktionalen Zusammenhang zwischen der Gleichgewichtsabsorption und der deponierten Dosis für die Messwerte gemäß der Fig. 6 an. Deutlich erkennbar ist eine Sättigung für hohe Dosen. Der Zusammenhang zwischen der Gleichgewichtsabsorption und der deponierten Dosis kann am besten durch eine Abhängigkeit mit R· H^{1,7} beschrieben werden, wobei R die Pulswiederholfrequenz (Repetitionsrate) bezeichnet

Die Sättigung der Gleichgewichtsabsorption bei hohen deponierten Dosen ist eine experimentelle Rechtfertigung für die vorstehend erläuterte Messvorschrift, die Gleichgewichtsabsorption einer Quarzglasprobe erst nach einer geeigneten Vorbestrahlung zu messen.

### Einfluss der Kühlung auf Quarzglasprobe

Unter Anwendung der vorgenannten Messvorschrift, gemäß der die Gleichgewichtsabsorption nach einer geeigneten Vorbestrahlung der Quarzglasprobe zu messen ist, wurde der Einfluss der Abkühlung eines Quarzglas-Rohteils auf die RDP bestimmt. Die nachfolgende Tab. 2 vergleicht die Ergebnisse einer erfindungsgemäß hergestellten Quarzglasprobe mit den entsprechenden Ergebnissen der Proben gemäß der Tab. 1.

**Tab. 2: Messungen des RDP an Lithosil-Proben verschiedener Herstellmethoden**

| | 98042C00-2 | 32124C51-3 | 30114C00-2 | 30114C00-2FK |
|---|---|---|---|---|
| Schmelzverfahren | vertikal | horizontal und Senken | horizontal | horizontal |
| Zusätzliche nachträgliche Kühlung der Probe | nein | nein | nein | ja |
| H₂ [10¹⁸/cm³] | 1,9 | 1,5 | 2,6 | Unterhalb der Nachweisgrenze |
| k₀ [10⁻³/cm] | 1,65 | 1,26 | 1,28 | 1,75 |
| dk/dH [10⁻⁴/cm] | 5,6 | 4,8 | 4,6 | 1,3 |

Die Nachweisgrenze für H₂ betrug etwa 0,2· 10¹⁸ Moleküle/cm³.

Die Angaben gemäß den Spalten 2 bis 4 der Tab. 2 entsprechen den Angaben gemäß der Tab. 1. Bei diesen Proben wurde ein Standard-Abkühlprozess zum Abkühlen der Vorform zu einem Quarzglas-Rohteil wie folgt ausgeführt: die Vorform wurde unmittelbar nach der Direktabscheidung mittels Flammenhydrolyse auf einer oberen Haltetemperatur im Bereich zwischen etwa 950°C und 1100°C während einer Haltezeit zwischen etwa 6h und 12h gehalten; anschließend wurde die Vorform mit einer Abkühlrate von etwa 5K/h bis etwa 50K/h auf eine Kühlendtemperatur zwischen etwa 800°C und 900°C abgekühlt.

Die Probe gemäß der letzten Spalte der Tab. 2 wurde hingegen einem zusätzlichen, nachträglichen Kühlprozess unterworfen, zu welchem Zweck die Probe nach Abkühlung erneut auf eine obere Haltetemperatur erwärmt und anschließend wie folgt abgekühlt wurde: die Probe wurde zunächst auf eine obere Haltetemperatur im Bereich zwischen etwa 950°C und 1150°C, bevorzugter im Bereich zwischen etwa 1050°C und 1100°C, erwärmt und auf der oberen Haltetemperatur während einer Haltezeit von mindestens etwa 10h, bevorzugter von mindestens 20h, gehalten; anschließend wurde die Vorform mit einer Abkühlrate von etwa 1K/h bis etwa 20K/h, bevorzugter zwischen etwa 2K/h und etwa 5K/h, auf eine Kühlendtemperatur zwischen etwa 700°C und etwa 950°C, bevorzugter zwischen etwa 800°C und etwa 900°C, abgekühlt.

Diese zusätzlich gekühlte Probe (30114C00-2FK) zeigt eine deutliche Verbesserung des dk/dH-Wertes. Der Messwert belegt die Beeinflussbarkeit der RDP-Eigenschaft durch Veränderung des Kühlprozesses.

Die Fig. 8a zeigt die Transmission einer solchermaßen hergestellten Quarzglasprobe in Abhängigkeit von der Anzahl Laserpulsen bei einer Energiedichte von 1,5 mJ/cm², wie diese den angedachten Anwendungen in der Mikrolithografie entspricht. Während der Bestrahlung beginnt die induzierte Absorption, was am stetigen Abfall der Transmission während der Bestrahlung erkennbar ist.

Als Vergleich ist in der Fig. 8b die Probe 30114c00_3 bei identischer Energiedichte dargestellt, die aus derselben Probencharge stammt, jedoch der nachträglichen Kühlung nicht unterzogen wurde. Eine Bestimmung des H₂-Gehalts in den Proben ergab, dass die Probe gemäß der Fig. 8b noch ausreichend Wasserstoff enthielt, während für die während der Bestrahlung auftretende induzierte Absorption die zusätzliche, nachträgliche Kühlung der Probe gemäß der Fig. 8a und das damit verbundene Austreiben des physikalisch gelösten Wasserstoffs verantwortlich gemacht werden konnte. Als kritischer Wert, ab dem eine Gleichgewichtsabsorption festgestellt werden konnte, wurde ein Wert für den H₂-Gehalt von 0,2· 10¹⁸ Moleküle/cm³ ermittelt.

In weiteren aufwändigen Versuchsreihen wurde der Einfluss der Kühlung auf das RDP-Verhalten weiter untersucht. Es ergab sich, dass Erfolg versprechende Wege zur Reduzierung des RDP bei Beibehaltung der nötigen geringen induzierten Absorption in der Aufrechterhaltung bzw. Schaffung einer geeigneten Wasserstoff-Konzentration in der Quarzglasprobe mittels der nachfolgenden Verfahrensvarianten bestehen:
(i) bei der gefundenen, in Tab. 2 dargestellten, verbesserten Kühlung unter Luftatmosphäre werden die Abmessungen des Quarzteiles so groß gewählt, dass nach dieser Kühlung ein ausreichend großes inneres Volumen des Quarzteiles mit genügend hohem H₂-Gehalt übrig bleibt; Randbereiche mit unzureichendem H₂-Gehalt müssen ggf. entfernt werden;
(ii) die gefundene, in Tab. 2 dargestellte, verbesserte Kühlung wird nicht unter Luftatmosphäre, sondern unter Wasserstoffatmosphäre durchgeführt. Die dabei nötige Wasserstoffkonzentration im Kühlofen kann über den Druck des Wasserstoffgases im Kühlofen gemäß dem erforderlichen Mindestgehalt an Wasserstoff im Quarzglas eingestellt werden, wie in EP 1 288 169 A1 offenbart, deren Inhalt hiermit im Wege der Bezugnahme ausdrücklich in der vorliegenden Anmeldung mit beinhaltet sei;
(iii) nach der gefundenen, in Tab. 2 dargestellten, verbesserten Kühlung unter Luftatmosphäre erfolgt die nachträgliche Anreicherung der Quarzteile mit Wasserstoff in einer zusätzlichen Temperung bei deutlich niedrigerer Temperatur und angepasster Wasserstoffkonzentration im Ofen, wie in EP 1 288 169 A1 offenbart.

Die Ergebnisse solcher Versuche sind beispielhaft in der nachfolgenden Tab. 3 zusammengefasst.

**Tab. 3**

| | 98042C00-3 | 98042C00-3FK | 98042C00-3FKH2 | 32124C51-FKP5 | 98024C00-30M |
|---|---|---|---|---|---|
| Kühlung von | Volumen | Probe | Probe | Volumen | Volumen |
| Haltetemperatur [°C] | 1070 | **1070** | **1070** | **1070** | 1070 |
| Haltezeit [h] | 10 | **20** | **20** | **20** | 3 |
| Kühlgeschwindigkeit [K/h] | 7 | **3** | **3** | **3** | 30 |
| Endtemperatur [°C] | 850 | **850** | **850** | **850** | 850 |
| H₂-Beladung | nein | nein | ja | nein | nein |
| H₂-Gehalt [10¹⁸cm⁻³] | 2,3 | unter der Nachweisgrenze | 1,5 | 0,2 | 2,2 |
| k₀ [10⁻³] | 1,86 | 2,04 | 1,73 | 1,73 | 2,18 |
| dk/dH [10⁻⁴] | 4,6 | 1,7 | 1,9 | 1,6 | 7,9 |

In der ersten Spalte der Tab. 3 ist eine Vergleichsprobe mit der vorgenanten Standard-Kühlung als Referenz angegeben; die in Fettschrift hervorgehobenen Parameter beschreiben den erfindungsgemäßen Kühlprozess.

Bei Proben mit einem H₂-Gehalt von oberhalb von 0,2· 10¹⁸ Moleküle/cm³ wurde während der Bestrahlung keine induzierte Absorption beobachtet. Dies war aufgrund von früheren Untersuchungen zur induzierten Absorption zu erwarten (vgl. U. Natura, O. Sohr, R. Martin, M. Kahlke, G. Fasold: "Mechanisms of radiation induced defect generation in fused silica", Proceedings of SPIE Volume 5273, 155-163 (2003)), worin gezeigt wurde, dass die Konzentration von Vorläuferdefekten, die zu induzierter Absorption führen können, in Lithosil < 1· 10¹⁷ Moleküle/cm³ beträgt, der verbleibende Wasserstoffgehalt also für die Ausheilung dieser Defekte ausreicht.

Insgesamt beträgt somit der notwendige H₂-Gehalt im Quarzglas mindestens 0,2· 10¹⁸ Moleküle/cm³, vorzugsweise 0,2· 10¹⁸ Moleküle/cm³ bis 3· 10¹⁸ Moleküle/cm³.

Zur Einstellung des Wasserstoff-Gehalts wurde gemäß einer weiteren Ausführungsform bei einem abgekühlten Quarzglas-Rohteil, das unter Luftatmosphäre von der Haltetemperatur auf die Kühlendtemperatur abgekühlt wurde, der Wasserstoff-Gehalt des Quarzglas-Rohteils zumindest abschnittsweise ermittelt, beispielsweise mittels Raman-Spektroskopie, und wurde auf der Grundlage des so ermittelten Wasserstoff-Gehalts Parameter für einen weiteren Temperaturzyklus für das Quarzglas-Rohteil unter einer Wasserstoffatmosphäre bei Normaldruck berechnet und der Temperaturzyklus unter der Wasserstoffatmosphäre bei Normaldruck ausgeführt.

Gemäß einer weiteren Ausführungsform wurde der H₂-Gehalt für äußere Randbereiche des Quarzglas-Rohteils ermittelt und der äußere Randbereich von dem Quarzglas-Rohteil mit einem H₂-Gehalt von weniger als 0,2· 10¹⁸ Moleküle/cm³ entfernt.

Da zur Flammenhydrolyse als Gase Wasserstoff und Sauerstoff verwendet werden und als chlorhaltiger Silizium-Precursor Siliziumtetrachlorid(SiCl₄) verwendet wird, beträgt der Gehalt an Chlor (Cl) im Quarzglas typischerweise mindestens 5 Masse-ppm, gemäß einigen Ausführungsformen mindestens 20 Masse-ppm. Der Gehalt an Chlor beträgt ferner vorzugsweise höchstens 50 Masse-ppm, bevorzugter höchstens 40 Masse-ppm. Dabei kann der Gehalt an SiOH im Quarzglas 800 bis 1400 Masse-ppm, vorzugsweise 1000 bis 1200 Masse-ppm, betragen.

Zur Charakterisierung solcher Quarzglas-Rohteile wurde die optische Absorption des Quarzglas-Rohteils für eine Mehrzahl von Laserpulsen bei einer Wellenlänge von 193nm und einer Energiedichte von bis zu H = 1,5 mJ/cm² mit einer vorbestimmten Wiederholfrequenz gemessen, nachdem das Quarzglas-Rohteil mit zumindest 2·10⁶ Laserpulsen, bevorzugter mit zumindest 3· 10⁶ Laserpulsen, bei einer Energiedichte von zumindest 2,5 mJ/cm², bevorzugter von zumindest 3 mJ/cm², bestrahlt wurde. Dann wurde das Quarzglas-Rohteil ausgesondert oder speziell weiterbehandelt, wenn sich kein Gleichgewichtswert für die optische Absorption bei der Messung einstellt. Wie vorstehend ausgeführt, konnte durch Fahren eines weiteren Temperaturzyklus unter geeigneten Bedingungen, insbesondere Wasserstoff-Gehalt der Atmosphäre, der Wasserstoff-Gehalt des Quarzglas-Rohteils geeignet eingestellt werden.

Dabei kann das Quarzglas-Rohteil beispielsweise dann ausgesondert oder speziell weiterbehandelt werden, wenn sich der Gleichgewichtswert für die optische Absorption nicht nach einer Bestrahlung von höchstens 10 min. eingestellt hat.

Gemäß einer weiteren Ausführungsform wird der Gleichgewichtswert für die optische Absorption für eine Mehrzahl von vorbestimmten Wiederholfrequenzen gemessen und aus den bestimmten Wiederholfrequenzen auf einen Gleichgewichtswert für die optische Absorption für hohe Wiederholfrequenzen extrapoliert, wie vorstehend ausgeführt, und das Quarzglas-Rohteil ausgesondert oder speziell weiterbehandelt wird, wenn die für die hohen Wiederholfrequenzen extrapolierte optische Absorption einen vorbestimmten Grenzwert überschreitet.

Die vorstehende Vorgehensweise kann selbstverständlich auch zur Charakterisierung, Aussonderung bzw. gesonderten Behandlung von Quarzglas-Rohteilen zur Herstellung eines Quarzglaskörpers mit geeigneter induzierter Absorption eingesetzt werden.

Somit wird erfindungsgemäß die Bereitstellung eines synthetischen Quarzglases mit verbesserten Eigenschaften für mikrolithographische Anwendungen, insbesondere in Bezug auf eine zuverlässige Einhaltung von die induzierte Absorption betreffenden Materialspezifikationen, ermöglicht.

## Patentansprüche

1. Synthetisches Quarzglas, herstellbar durch Direktabscheidung mittels Flammenhydrolyse eines Silizium-Precursors, insbesondere eines chlorhaltigen Silizium-Precursors, welches Quarzglas bei einer Bestrahlung mit Laserpulsen bei einer Wellenlänge von 193 nm, bei einer Energiedichte (H) von bis zu H = 1,5 mJ/cm² und bei einer Wiederholfrequenz der Laserpulse von bis zu R = 4 kHz, **gekennzeichnet ist durch** die folgenden Eigenschaften:
- im Bereich von Energiedichten von bis zu 1,5 mJ/cm² steigt die Gleichgewichtsabsorption des Quarzglases sublinear mit der Energiedichte für alle Wiederholfrequenzen der Laserpulse;
- die Abhängigkeit der Gleichgewichtsabsorption von der Wiederholfrequenz der Laserpulse ist sublinear; und
- der Zusammenhang von Gleichgewichtsabsorption und Energiedichte (H) lässt sich als Funktion von H^{1,7} beschreiben;
wobei der H₂-Gehalt mindestens 0,2· 10¹⁸ Moleküle/cm³ beträgt.

2. Synthetisches Quarzglas nach Anspruch 1, wobei sich der Zusammenhang von Gleichgewichtsabsorption und Energiedosis (R·H) als Funktion von R·H^{1,7} beschreiben lässt und für große Dosen sättigt.

3. Synthetisches Quarzglas nach einem der vorhergehenden Ansprüche, wobei zur Flammenhydrolyse als Gase Wasserstoff und Sauerstoff verwendet werden und der chlorhaltige Silizium-Precursor Siliziumtetrachlorid (SiCl₄) ist.

4. Synthetisches Quarzglas nach einem der vorhergehenden Ansprüche, wobei der Gehalt an Chlor (Cl) im Quarzglas 5 bis 50 Masse-ppm beträgt.

5. Synthetisches Quarzglas nach einem der vorhergehenden Ansprüche, wobei der Gehalt an SiOH im Quarzglas 800 bis 1400 Masse-ppm, vorzugsweise 1000-1200 Masse-ppm, beträgt.

6. Synthetisches Quarzglas nach einem der vorhergehenden Ansprüche, wobei der H₂₋Gehalt im Quarzglas mindestens 0,2· 10¹⁸ Moleküle/cm³, vorzugsweise 0,2· 10¹⁸ Moleküle/cm³ bis 3· 10¹⁸ Moleküle/cm³, beträgt.

7. Verfahren zur Herstellung eines Körpers aus einem synthetischen Quarzglas, insbesondere aus einem synthetischen Quarzglas nach einem der vorhergehenden Ansprüche, durch Direktabscheidung eines Quarzglas-Rohteils mittels Flammenhydrolyse eines Silizium-Precursors, insbesondere eines chlorhaltigen Silizium-Precursors, wobei das Quarzglas-Rohteil
- auf einer oberen Haltetemperatur im Bereich von 950°C bis 1150°C, vorzugsweise 1050°C bis 1100°C, für mindestens 10h, bevorzugter für mindestens 20h, gehalten wird, und
- auf eine Kühlendtemperatur mit einer mittleren Abkühlgeschwindigkeit von 1 K/h bis 20 K/h, vorzugsweise von 2 K/h bis 5 K/h, abgekühlt wird,
und der H₂-Gehalt des Quarzglaskörpers auf mindestens 0,2· 10¹⁸ Moleküle/cm³ eingestellt wird.

8. Verfahren nach Anspruch 7, wobei das nach der Flammenhydrolyse abkühlte Quarzglas-Rohteil auf die obere Haltetemperatur aufgeheizt wird.

9. Verfahren nach Anspruch 7 oder 8, wobei die Kühlendtemperatur 700°C bis 950°C, vorzugsweise 800°C bis 900°C, beträgt.

10. Verfahren nach einem der Ansprüche 7 bis 9, wobei das Quarzglas-Rohteil nach der Direktabscheidung in einem oder mehreren Schritten zu dem Quarzglaskörper thermisch umgeformt wird.

11. Verfahren nach einem der Ansprüche 7 bis 10, wobei zum Einstellen des H₂-Gehalts des Quarzglaskörpers das Quarzglas-Rohteil unter einer Luftatmosphäre oder unter einer Wasserstoffatmosphäre unter Normaldruck von der Haltetemperatur auf die Kühlendtemperatur gekühlt wird.

12. Verfahren nach einem der Ansprüche 7 bis 10, wobei das Quarzglas-Rohteil unter Luftatmosphäre von der Haltetemperatur auf die Kühlendtemperatur gekühlt wird, wobei zum Einstellen des H₂-Gehalts des Quarzglaskörpers der H₂-Gehalt des Quarzglas-Rohteils zumindest abschnittsweise ermittelt wird und auf der Grundlage des so ermittelten H₂₋Gehalts Parameter für einen weiteren Temperaturzyklus für das Quarzglas-Rohteils unter einer Wasserstoffatmosphäre bei Normaldruck berechnet und der Temperaturzyklus unter der Wasserstoffatmosphäre bei Normaldruck ausgeführt wird.

13. Verfahren nach einem der Ansprüche 7 bis 12, wobei der H₂-Gehalt für äußere Randbereiche des Quarzglas-Rohteils ermittelt wird und äußere Randbereiche von dem Quarzglas-Rohteil mit einem H₂-Gehalt von weniger als 0,2· 10¹⁸ Moleküle/cm³ entfernt werden.

14. Verfahren nach einem der Ansprüche 7 bis 13, wobei eine optische Absorption des Quarzglas-Rohteils für eine Mehrzahl von Laserpulsen bei einer Wellenlänge von 193nm und einer Energiedichte von bis zu H = 1,5 mJ/cm² mit einer vorbestimmten Wiederholfrequenz gemessen wird, nachdem das Quarzglas-Rohteil mit zumindest 2· 10⁶ Laserpulsen, bevorzugter mit zumindest 3· 10⁶ Laserpulsen, bei einer Energiedichte von zumindest 2,5 mJ/cm², bevorzugter von zumindest 3 mJ/cm², bestrahlt wurde, wobei das Quarzglas-Rohteil ausgesondert oder speziell weiterbehandelt wird, wenn sich kein Gleichgewichtswert für die optische Absorption bei der Messung einstellt.

15. Verfahren nach Anspruch 14, wobei das Quarzglas-Rohteil ausgesondert oder speziell weiterbehandelt wird, wenn sich der Gleichgewichtswert für die optische Absorption nicht nach einer Bestrahlung von höchstens 10 min. eingestellt hat.

16. Verfahren nach Anspruch 14 oder 15, wobei der Gleichgewichtswert für die optische Absorption für eine Mehrzahl von vorbestimmten Wiederholfrequenzen gemessen wird und aus den bestimmten Wiederholfrequenzen auf einen Gleichgewichtswert für die optische Absorption für hohe Wiederholfrequenzen extrapoliert wird und das Quarzglas-Rohteil ausgesondert oder speziell weiterbehandelt wird, wenn die für die hohen Wiederholfrequenzen extrapolierte optische Absorption einen vorbestimmten Grenzwert überschreitet.

17. Verfahren zur Herstellung eines Quarzglaskörpers aus einem Quarzglas-Rohteil aus einem synthetischen Quarzglas nach einem der Ansprüche 1 bis 6, wobei eine optische Absorption des Quarzglas-Rohteils für eine Mehrzahl von Laserpulsen bei einer Wellenlänge von 193nm und bei einer Energiedichte von bis zu H = 1,5 mJ/cm² mit einer vorbestimmten Wiederholfrequenz gemessen wird, nachdem das Quarzglas-Rohteil mit zumindest 2· 10⁶ Laserpulsen, bevorzugter mit zumindest 3· 10⁶ Laserpulsen, mit einer Energiedichte von zumindest 2,5 mJ/cm², bevorzugter von zumindest 3 mJ/cm², bestrahlt wurde, und das Quarzglas-Rohteil ausgesondert oder speziell weiterbehandelt wird, wenn sich kein Gleichgewichtswert für die optische Absorption bei der Messung einstellt.

18. Verfahren nach Anspruch 17, wobei das Quarzglas-Rohteil ausgesondert oder speziell weiterbehandelt wird, wenn sich der Gleichgewichtswert für die optische Absorption nicht nach einer Bestrahlung von höchstens 10 min. eingestellt hat.

19. Verfahren nach Anspruch 17 oder 18, wobei der Gleichgewichtswert für die optische Absorption für eine Mehrzahl von vorbestimmten Wiederholfrequenzen gemessen wird und aus den bestimmten Wiederholfrequenzen auf einen Gleichgewichtswert für die optische Absorption für hohe Wiederholfrequenzen extrapoliert wird und das Quarzglas-Rohteil ausgesondert oder speziell weiterbehandelt wird, wenn die für die hohen Wiederholfrequenzen extrapolierte optische Absorption einen vorbestimmten Grenzwert überschreitet.
